# EUROPEAN PATENT APPLICATION

(11) **EP 4 831 342 A1**
(43) Date of publication of application: **28.10.2026**
(21) Application number: 26171473.7
(22) Date of filing: 09.04.2026
(51) Int. Cl.: C23C 16/30, C23C 16/50, F16K 24/06, F16K 25/00

(54) **VACUUM-PREVENTION VALVE WITH IMPROVED SEAL AND RELATED METHOD OF MANUFACTURE**

(30) Priority: 22.04.2025 IT 202500009000
(71) Applicant: Albertinari S.r.l., 28883 Gravellona Toce (VB) (IT); Antec Finiture Srl, 20871 Vimercate (MB) (IT)
(72) Inventor: ALBERTINARI, Giacomo, 28883 Gravellona Toce (VB) (IT)
(74) Representative: Faggioni, Carlo Maria

(57) **Abstract**

A vacuum preventing valve and its related method of production for a pressure-resistant container is disclosed, comprising a metallic valve body (1) provided with a sealing seat and a metallic valve pin (2), mounted longitudinally movable in said valve body (1), provided with a housing portion for a sealing gasket (3) of polymeric material, wherein at least surfaces (T) of said sealing seat and said housing portion of the valve pin are coated with a nanometric layer with a composition a:SiCOH.

## Description

### FIELD OF THE INVENTION

The present invention relates to a vacuum preventing valve for household appliances, such as coffee makers, coffee machines, steam irons and the like. The invention also relates to a method of production of said valve.

### BACKGROUND OF THE INVENTION

As is known, a vacuum breaker valve or vacuum preventing valve is a device that allows balancing the internal pressure of a container or tank with respect to the external pressure to the same container (normally atmospheric pressure) so that the container or tank never drops significantly below the external pressure. These valves are typically used in small household appliances such as coffee makers, coffee machines, steam irons and the like.

The vacuum preventing valve therefore protects containers, tanks or piping systems from negative pressure that may occur in certain circumstances (for example during the emptying of the tank or following the cooling of the internal volume), preventing damage due to deformation and squeezing from occurring. Vacuum preventing valves find particular application in small household appliances, medical equipment or coffee machines where boilers or tanks are used in which steam is formed and then released for various purposes.

To this end, the vacuum preventing valve is designed to be sensitive to the differential value between the external atmospheric pressure and the internal pressure of the tank and opens, allowing ventilation, when the differential falls below certain design thresholds. Traditionally, the vacuum preventing valve consists of a valve body in which a valve pin is freely mounted longitudinally, said pin being provided with a sealing gasket intended to cooperate with a respective valve seat. The pin can bring the sealing gasket to bear against the valve seat by simple gravity (the weight of the pin stem defines the pressure differential that leads to the opening of the valve) or by means of a suitably calibrated elastic element.

In order for the vacuum preventing valves to function reliably, it is necessary to keep them clean, in particular by preventing dust and dirt from settling in the valve opening and also by preventing the gasket from sticking to its seat.

These conditions are not simple to satisfy in aggressive environments such as steam boilers, where limescale formation occurs.

The gaskets are normally constituted by O-rings of elastomeric material, which guarantee an excellent seal, but are subject to sticking - precisely because these valves are intended to remain closed for a long time - and in any case impose limited operating temperatures. An example of a vacuum preventing valve for automotive use is disclosed in US 5960823.

To prevent the valve from being blocked by limescale or other dirt, it has been proposed to insert a bush made of Teflon^{™}, which, by its chemical nature, does not allow anything to adhere, neither the gasket nor the limescale.

However, Teflon^{™} - as well as other similar materials - is a fluorinated material from the PFAS family of compounds (per-e polyfluoroalkyl substances) which is considered harmful to health and the environment and could be unwelcome in many applications.

US 4991822 describes a coating treatment applied to flat bodies of generic valves, which provides for the deposition of a carbon-based material. The proposed treatment is not suitable for gaskets made of plastic materials and, moreover, uses amorphous hydrogenated carbon a:CH which is polar and has a high surface tension, thus disadvantageously causing the growth of calcareous concretions.

### SUMMARY OF THE INVENTION

The problem at the basis of the invention is therefore to supply a vacuum preventing valve that can be free of PFAS compounds and at the same time guarantee a good seal without the need to resort to costly maintenance.

This object is achieved through the features mentioned in claim 1.

The dependent claims describe preferential features of the invention.

The solution proposed here consists in subjecting at least the metallic parts of the valve that cooperate with the gasket of plastic material (elastomer, for example) to a high-vacuum plasma-assisted chemical deposition process, with which a nanometric thickness coating is created with a siloxane-based atmosphere.

This coating, for a modest additional production cost, guarantees that neither dirt nor calcareous sediments will deposit on the valve surfaces cooperating with the gasket, to the benefit of the effectiveness and duration of the gasket and therefore of the functioning of the vacuum preventing valve.

### BRIEF DESCRIPTION OF THE DRAWINGS

Further characteristics and advantages of the invention will in any case become more evident from the following detailed description of a preferred embodiment, given by way of nonlimiting example and illustrated in the appended drawings, in which:
fig. 1 is a longitudinal sectional view of an exemplary vacuum preventing valve;
fig. 2 is an exploded perspective view of the valve of fig. 1; and
fig. 3 is a side elevation view, partially in longitudinal section, of a variant of a vacuum preventing valve.

### DETAILED DESCRIPTION OF A PREFERRED EMBODIMENT

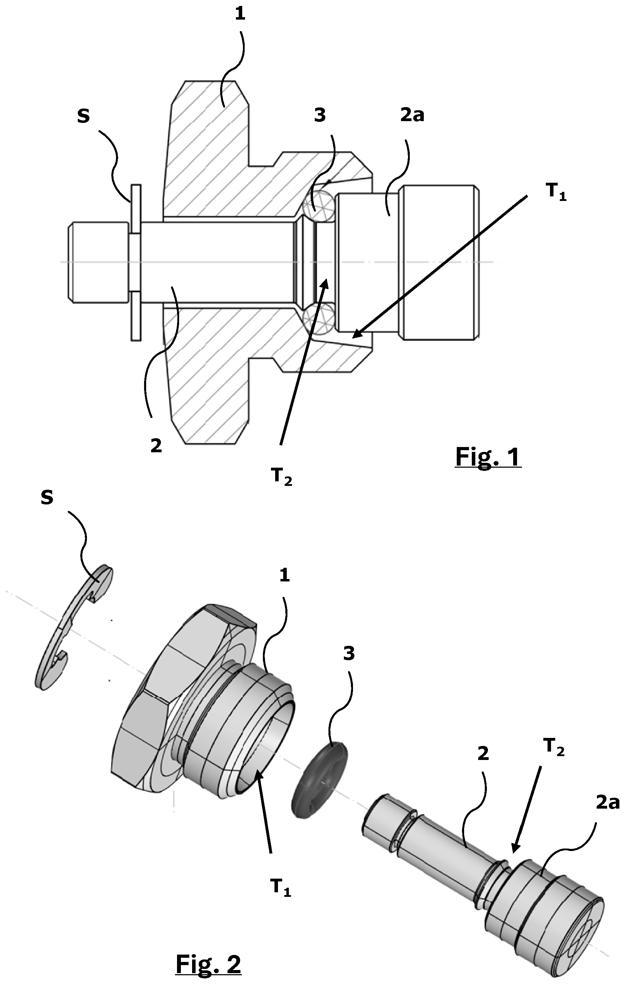

The figures illustrate an exemplary vacuum preventing valve, comprising a valve body 1 in which is freely inserted longitudinally a valve pin or plunger 2 provided with a sealing gasket 3 intended to cooperate with a respective valve seat (as visible in fig. 1).

The sealing gasket 3 is typically formed by an O-ring of circular cross-section of polymeric material, for example silicone, but it can also have a different cross-section and material.

The valve pin has a head 2a of larger diameter, intended to push the O-ring gasket 3 to bear against its valve seat. On the opposite side from the head 2a of larger diameter, the valve pin has an annular groove in which a Seeger ring (or similar) S engages, which prevents the valve pin 2 from sliding out of the valve body 1.

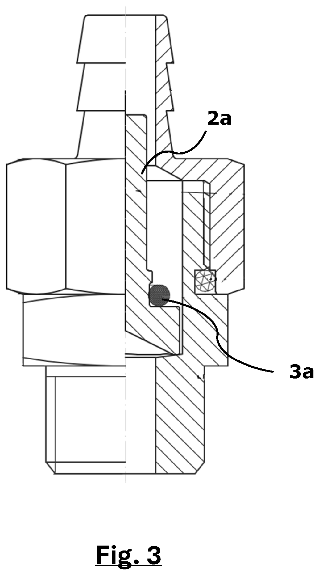

An alternative version (see fig. 3) provides that the valve pin 2a is inserted and constrained inside a valve body made of two components reciprocally coupled after the insertion of the valve pin. This variant also provides for a gasket 3a that works in a similar way to the first embodiment.

This configuration, typical of a gravity valve, may also have variants or significant differences, for example in vacuum preventing valves equipped with elastic means for closing the valve pin; in any case, the common element is the presence of a longitudinally mobile valve pin, provided with a sealing element that guarantees the seal against the surface of a valve seat.

This type of valve is intended to be mounted on a boiler or pressure container - for example by screwing the valve body 1 - with the valve head 2a facing the inner side of the container, so as to keep the valve always closed when there is an internal pressure higher than the external (atmospheric) pressure. For most of its operating time, the vacuum preventing valve therefore remains closed. When the internal pressure of the container tends to go 'into a vacuum', i.e., lower than the external pressure, the vacuum preventing valve opens and lets air seep from the outside into the container to compensate for the pressure difference.

According to the invention, at least the surfaces T₁ of the valve body 1 seat on which the sealing gasket 3 bears and possibly the corresponding surface T₂ of the valve pin 2 in which the gasket 3 is housed, are coated with a nanometric layer of a silica-based film, often identified on the market as silicon oxide, SiOx, but more precisely of a:SiCOH composition obtained by high-vacuum plasma-assisted chemical deposition.

The thickness of this a:SiCOH (or SiOx) coating on the metallic surface of the valve body seat and possibly of the valve pin can have a variable magnitude between 50 and 2500 nm (measured by interferometry technique) depending on the geometry of the final piece.

A coating of hydrogenated amorphous silicon, a:SiCOH, can be obtained, preferably with Si at a percentage higher than 60% and carbon with a percentage lower than 30%. The amorphous a:SiCOH coating obtained by cold plasma from organosiloxane gas is characterized by a Si-O-Si lattice structure interrupted by Si-C and Si-CH₃ bonds, conferring hydrophobicity and very low surface tension.

Advantageously, the sealing gasket 3, 3a of polymeric material can also be subjected to the same plasma-assisted chemical deposition process to form a nanometric layer of SiCOH.

The nanometric a:SiCOH / SiOx coating is obtained by subjecting the metallic valve body and valve pin to a high-vacuum plasma-assisted chemical deposition treatment (abbreviated PECVD or PACVD), by ionizing gas mixtures comprising siloxanes, such as hexamethyldisiloxane (HMDSO) and tetramethylsilane (TMS), and oxygen.

The valve body and the valve pin, before being assembled, are exposed in the plasma chamber so that the coating mainly affects the surfaces where the gasket 3 is intended to provide a seal, but it is not excluded that other metallic surfaces may also be partially coated, without this causing any type of problem for the functioning of the valve.

It has been found that the coating thus formed adheres perfectly to the metallic surface (normally aisi 303 stainless steel or similar, but also austenitic, ferritic, martensitic steels and some types of brass) and confers hydrophobic and antiadhesion properties that prevent the accumulation of limescale and also the adhesion of the sealing gasket 3. The deposited coating is in fact hydrophobic, has a low surface tension, and is non-polar.

In the case of the sealing gasket, the process is similar, but it must be taken into account that the polymeric material is not conductive.

In PECVD processes there are in fact different ways of generating the plasma: for the considered application it is appropriate to use systems equipped with radio frequency or medium frequency generators. The generators must be connected to an antenna, which ionizes the gas by effect of the electromagnetic field generated by the passage of current between the antenna, the anode, and the chamber, the cathode, through the gas that is ionized.

In the case of the non-conductive polymeric gasket, the coating is obtained by placing the pieces to be treated in a system equipped with a fixed antenna, thus the plasma is generated in the chamber, and the pieces are passed through the plasma in bulk, with systems that move them constantly, for example in a rotating drum.

In the case of the metallic valve body, instead, preferably the conductive pieces can be used themselves as an antenna, generating a bias, a potential difference, by passing current through the pieces which are therefore connected to the RF or MF generator. This allows obtaining a coating that is more resistant to wear and less porous.

This does not preclude that even in the case of the metallic valve body a process like that of the gaskets can be used, without them being connected to an electrical potential, which could be preferable with certain very complex geometries for which the passage of current in the pieces could give rise to a point effect, hollow cathode or even the formation of arcs.

Although an a:SiCOH plasma coating is in itself already suitable for the desired functioning, advantageously further process steps can be provided to further improve the adhesion of the nanometric layer or the properties of the layer itself. For example, it is preferable to perform preventive washes with degreasing and passivating substances, ultra-fine cleaning in vacuum with argon plasma, etching with nitrogen, argon or oxygen plasma which are suitable for priming the surface for the maximum yield of the deposition process.

The a:SiCOH coating obtained with plasma treatment according to the invention allows to perfectly achieve the objects set out in the premises. This coating is in fact PFAS-free, does not require costly interventions on the valves (several valve units can be treated simultaneously in the same plasma treatment chamber) and is perfectly compatible with the applications for which these vacuum preventing valves are intended. The coating is durable and ensures perfect functioning of the vacuum preventing valve even without particular maintenance.

It is understood, however, that the invention should not be considered limited to the particular embodiment illustrated above, which should be considered exemplary, but that different variants are possible, all within the reach of a person skilled in the art, without thereby departing from the scope of protection of the invention itself as defined by the claims that follow.

## Claims

1. A vacuum preventing valve for a pressure-resistant container, comprising a metallic valve body (1) provided with a sealing seat and a metallic valve pin (2), mounted longitudinally movable in said valve body (1), provided with a housing portion for a sealing gasket (3) of polymeric material, **characterized in that**
at least surfaces (T) of said sealing seat and said housing portion of the valve pin are coated with a nanometric layer with a composition of hydrogenated amorphous silicon a:SiCOH.

2. The valve according to claim 1, wherein said nanometric layer has a thickness in the order of 50 to 2500 nm.

3. The valve according to claim 1 or 2, wherein said nanometric layer with a composition of hydrogenated amorphous silicon a:SiCOH is obtained by plasma-assisted chemical deposition (PECVD or PACVD) .

4. The valve according to claim 1, 2 or 3, wherein said polymeric material is PFAS-free.

5. The valve according to any one of the preceding claims, wherein said composition of hydrogenated amorphous silicon, a:SiCOH, has silicon in a percentage higher than 60% and carbon in a percentage lower than 30%.

6. A method of production of a vacuum preventing valve according to claim 1, **characterized in that**
- before assembling said valve pin (2) in said valve body (1), at least surfaces (T) of a sealing seat of the valve body (1) and optionally a housing portion for a gasket (3) of the valve pin (2) are subjected to a plasma deposition treatment of a nanometric coating having a composition of hydrogenated amorphous silicon a:SiCOH.

7. The method of production according to claim 6, wherein a sealing gasket of polymeric material is also subjected to a plasma deposition treatment of a nanometric coating having a composition of hydrogenated amorphous silicon a:SiCOH.

8. The method of production according to claim 6 or 7, wherein said plasma treatment is a plasma-assisted chemical deposition of the PECVD or PACVD type where gases such as argon, nitrogen, oxygen, and precursors such as HMDSO and TMS are used.

9. The method of production according to claim 6, 7 or 8, wherein said nanometric coating having a composition of hydrogenated amorphous silicon a:SiCOH is obtained by means of cold plasma from organosiloxane gas.

10. The valve according to any one of claims 6 to 9, wherein said composition of hydrogenated amorphous silicon, a:SiCOH, has silicon in a percentage higher than 60% and carbon in a percentage lower than 30%.

11. The method of production according to claim 7, wherein said polymeric material is PFAS-free.
